Europäisches Patentamt

(19) European Patent Office

Office européen des brevets

(11) Publication number: **0 017 316**

A2

## (12) EUROPEAN PATENT APPLICATION

(21) Application number: **80300362.3**

(22) Date of filing: **07.02.80**

(51) Int. Cl.³: **G 03 F 7/16**
**G 03 F 7/20**

(30) Priority: **09.02.79 GB 7904705**

(43) Date of publication of application:
**15.10.80 Bulletin 80/21**

(84) Designated Contracting States:
**AT BE CH DE FR IT LU NL SE**

(71) Applicant: **UNIROYAL LIMITED**

**Newbrigde Midlothian EH28 8LG, Scotland(GB)**

(72) Inventor: **Thawley, Clive Stafford**
**5 Robertson Avenue**
**Dumfries Scotland(GB)**

(72) Inventor: **Graham, Kenneth**
**14 Canterbury Avenue Lowton Saint Lukes**
**Near Warrington Cheshire(GB)**

(72) Inventor: **Brittain, Austin**
**25 Minden Crescent**
**Georgetown Road Dumfries Scotland(GB)**

(74) Representative: **Geldard, David Guthrie et al,**
**Urquhart-Dykes & Lord 11th Floor Tower House Merrion**
**Way**
**Leeds, LS2 8PB(GB)**

(54) **Processing the surface of cylindrical objects.**

(57) Apparatus for treating the surface of a cylindrical object (e.g. an exposed photopolymer printing sleeve) in a number of sequential steps. A plurality of cylinders are supported in an enclosure one each on a plurality of carriers (8 to 11) rotated by a transmission from a motor (48). Each cylinder is rotatable past a hot air drying inlet unit (55, 56), an ultraviolet exposure unit (53) and a unit (58,59) for spraying a detack-ifying solution. The units are operational in required sequence for simultaneously and equally treating the surface of each cylindrical object.

EP 0 017 316 A2

./...

FIG.1

TITLE MODIFIED
see front page

- 1 -

"PROCESSING THE SURFACE OF CYLINDRICAL OBJECTS"

This invention relates to apparatus for treating the surfaces of cylindrical objects in a number of sequential steps.

There are many fields wherein it is necessary to treat the outer surface of a cylinder by a succession of processes, and many methods of handling the cylinder during that treatment have been used. The objective of the present invention is to provide a compact apparatus which can be used for processing cylinders and which is designed to ensure that the whole surface of the cylinder can be equally treated in each process step.

According to the present invention, apparatus for treating the surface of a cylindrical object in a number of sequential steps comprises an enclosure, mounting means in the enclosure for releasably engaging opposite ends of a cylindrical object to support said object within the enclosure, drive means for rotating said mounting means to rotate said object about its axis, a plurality of treatment means directed towards the location of said object when mounted, and means controlling operation of the treatment means in a desired sequence as said object is rotated.

The mounting of the object in an enclosure within which all necessary process steps are effected removes

- 2 -

the need for transferring the cylinder from one processing location to another.

Preferably the apparatus is designed to be used with the object mounted so that its axis is vertical and each treatment means is designed to apply treatment simultaneously over the full axial length of the object. This optimises uniform treatment of the full surface of the object.

Preferably a plurality of mounting means are provided in a common enclosure so that a number of objects may be simultaneously treated. Clearly the number and distribution of the treatment means is then arranged so that the surfaces of all the objects are treated equally and simultaneously. This arrangement is particularly suitable when the object has to be treated by process steps which differ in duration as it allows a number of objects to be simultaneously processed in the minimum necessary time.

Where a plurality of mounting means are provided they are conveniently driven from a common drive.

The apparatus is particularly suitable for use in the finishing of photopolymer printing cylinders. Such cylinders have been exposed through a negative to ultra-violet light and the areas so exposed have hardened due to that exposure, leaving soft unexposed areas between the hardened areas. After this exposure the soft material is then brushed out from the surface of the cylinder by means of a solvent applied in a brushing unit, so giving a cylinder with a relief printing surface. The cylinder must then be dried to remove the solvent, post-exposed to expose the whole surface of the cylinder to ultra-violet radiation, detackified by a suitable liquid agent and then finally dired. These four finishing steps may all be carried out in the enclosure of apparatus according to the invention.

Thus, from another aspect the invention resides in apparatus for treating the exposed surfaces of a photopolymer printing sleeve of cylindrical form, the apparatus comprising an enclosure, mounting means within the enclosure for releasably engaging opposite ends of the sleeve to support the sleeve within the enclosure, drive means for rotating said mounting means to rotate said object about its axis, first treatment means for directing ultra-violet light on to a surface band extending the full axial length of the object, second treatment means for spraying a detackifying solution onto a surface band extending the full axial length of the object, third treatment means for drying the full axial length of the surface of the object, the three treatment means being angularly spaced around the location of the object and means controlling operation of the treatment means in a desired sequence as said object is rotated.

In order that the invention may be better understood a specific embodiment thereof will now be described in more detail, by way of example only, with reference to the accompanying drawings in which:-

Figure 1 is a top plan view of the apparatus;

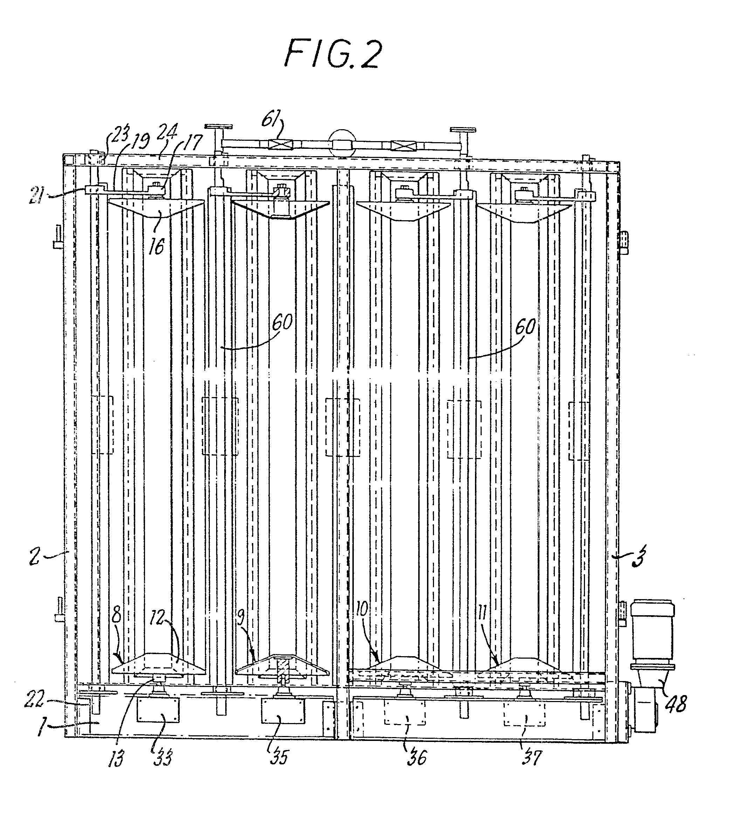

Figure 2 is a side elevation of the apparatus with parts thereof removed;

Figure 3 is a cross-section on the line III-III of Figure 1, with parts omitted for clarity;

Figure 4 is a section on the line IV-IV of Figure 1, again with parts omitted for clarity;

Figure 5 is a sequence diagram; and

Figure 6 is a schematic control diagram.

The apparatus comprises a base 1 from which extends two side walls 2 and 3 and a rear wall 4. Between the rear wall 4 and the front of the apparatus are elements combining to form an intermediate wall generally indicated as 5. The front of the apparatus may be closed by doors, only one door 6 being shown in the drawing, there being a similar door at the left hand side. The side walls 2 and 3, intermediate wall 5 and doors 6 combine to form an enclosure 7.

Four carriers, shown generally as 8 to 11 are mounted in the enclosure. The carriers are identical and only the carrier 8 will be described in detail. This carrier comprises a lower conical mounting plate 12 having a central depending bush 13 which may fit over a keyed driving shaft 14. A hollow cylindrical sleeve 15 to be treated, the sleeve having an inner surface 15a and an outer surface 15b may be located on the conical mounting plate 12. The mounting means also comprises an upper conical mounting plate 16 capable of engaging the upper end of the sleeve 15. It will be seen that the sleeve 15 is tapered at each end from its inner surface 15a to its outer surface 15b, and that the taper matches the taper of the plates 12 and 16. The sleeve is thus centred relative to the plates 12 and 16 and as the axes of those plates are vertically aligned the sleeve is therefore held with its axis substantially vertical.

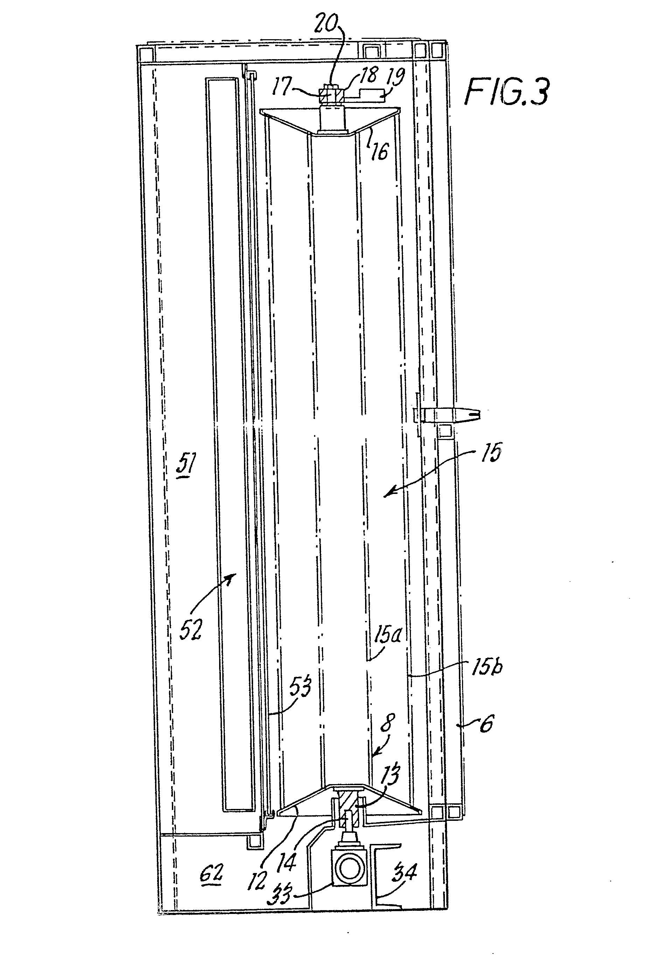

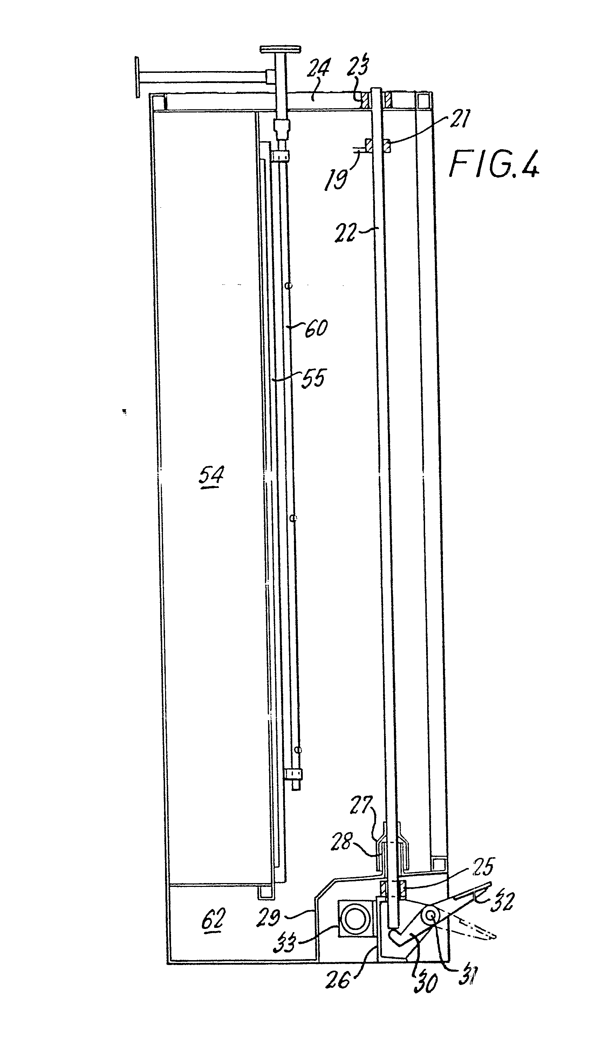

The upper conical mounting plate 16 has a pin 17 extending upwardly therefrom over which is fitted a boss 18 carried at one end of a link member 19. The other end of the link member 19 carries a further boss 21 which is secured by a grub screw (not shown) to a rod 22 supported for vertical movement in a first sliding bush 23 formed in a top wall 24 of the apparatus, and a sliding bush 25 fitted to a support 26 at the lower part of the apparatus. The rod is also guided for vertical movement by a sleeve 27 secured to the rod and fitting over a sleeve 28 upstanding from a cover 29. The lower end of the rod 22 rests in engagement with one arm 30 of a lever pivoted at 31, the other arm of the lever terminating in a pedal 32. It will be seen that with the pedal in the full line position shown in Figure 3 the upper conical mounting plate 16 is in the position shown in Figure 4 to hold a cylinder 15 in position. By depressing the pedal 32 the rod 22 is lifted so lifting the upper conical mounting plate 16 to increase the spacing between this and the lower plate 12 so allowing cylinders to be mounted between the plates and removed from between the plates.

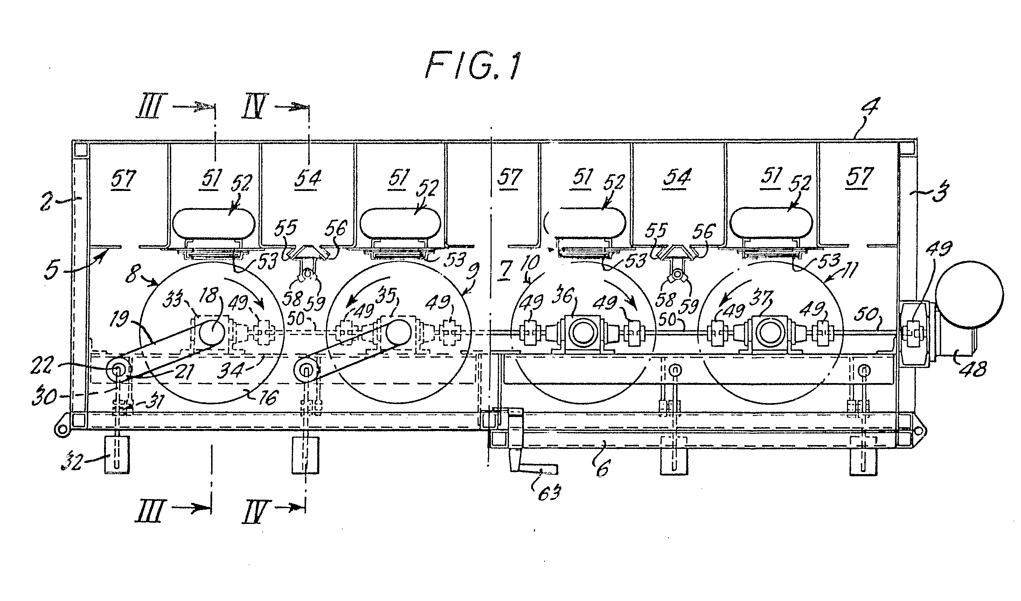

The drive spindle 14 is supported by thrust bearings to support the load provided by the cylinder and forms the drive output from a bevel gear box 33 bolted to a support 34 in the lower part of the apparatus. Similar bevel gear boxes 35, 36 and 37 are provided for the carriers 9, 10 and 11. Drive to each of the four boxes is derived from a motor 48 by way of couplings 49 and shafts 50. When the motor 48 is running it will be seen that all the lower mounting plates of the carriers rotate simultaneously, but (due to the arrangement of gears in the respective bevel gear boxes) in opposite directions as indicated by the arrows in Figure 1, and thus any cylinders mounted on those plates are also rotated simultaneously.

The space betwen the rear wall 4 and the intermediate wall 5 is divided into a series of compartments. Compartments 51 each house an assembly 52 of ultra-violet tubes which, through windows 53 at the front of the compartments are capable of irradiating the surface of cylinders mounted on the carriers. The tubes and windows extend the full length of the cylinder so that the whole of the surface may be irradiated.

Compartments 54 are connected to a pressurised source of hot air by suitable duct work (not shown). Each compartment 54 has two outlet vents 55 and 56 which are open for the full height of the apparatus and act to direct streams of hot air onto the surfaces of cylinders lying to each side of the compartments 54. Compartments 57 are air extraction compartments to which suction is applied to draw off the air from within the enclosure. Such air may be re-circulated and re-heated to be used again in a closed system. If volatile solvents are extracted from the cylinder surface during the drying process then those solvents, or at least a part of them, may be removed from the exhaust air before this is recycled. Any air supply and recycling system may be used and details are not shown in the drawing.

Mounted on the front of each of the compartments 54 are a series of pairs of spray nozzles 58 and 59 directed towards the surfaces of cylinders mounted to each side of the respective compartments. The nozzles are connected to supply pipes 60 which extend through the top wall 24 of the apparatus and are connected by duct work 61 to a pump (not shown) for supplying liquid under pressure. The nozzles are so arranged and designed that liquid is sprayed on to the whole axial length of the cylinders. The sleeves 27 and the cover 29 prevent excess liquid draining on to the drive and pedal systems and such liquid may collect in the space 62 at the bottom of the apparatus and may be drained therefrom and re-circulated. Again, no details of the re-circulation system are shown as this can take any suitable form.

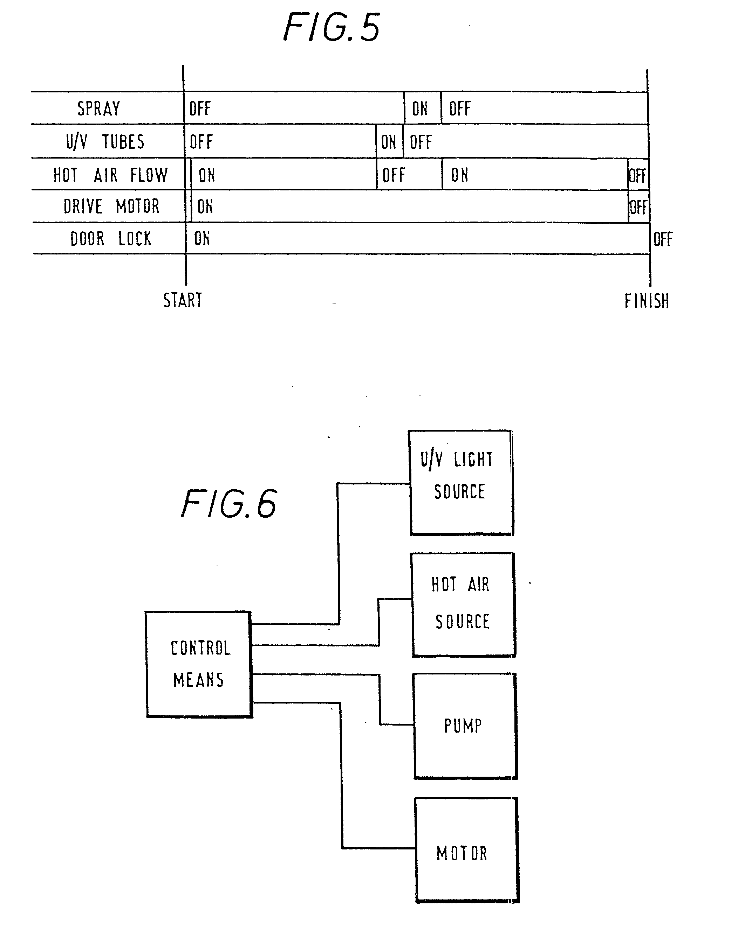

The apparatus also includes timing and control systems for controlling the operation. Any conventional timer may be used, that is capable of operating, in sequence, switches for energising and de-energising the drive motor 48, fans and a heater for the hot air input and extraction, ultraviolet tubes and pump and/or solenoid controlled valves for the spray system. Suitable conventional circuitry will be readily apparent to those skilled in the art and detailed description is unnecessary. However, to facilitate understanding a sequence diagram is given in Figure 5, showing operation of the apparatus in the context of processing exposed photopolymer cylinders.

The diagram is intended to illustrate the sequence only, and not to indicate actual relative times for the individual steps, which may vary considerably.

Up to four cylinders may be processed simultaneously and they are mounted in the enclosure by opening the doors 6, raising the upper conical mounting plates 16, positioning the cylinders on the lower conical mounting plates 12 and lowering the plates 16 to centre the cylinders and hold them between the pairs of plates 12 and 16. When all the cylinders are properly mounted the doors 6 are closed and locked by the lock 63, closing a safety switch enabling the timer to be started under control of a start switch. Closing this switch operates an interlock to prevent door lock 63 being opened, and then starts motor 48 so that the drive system thus causes all the cylinders to rotate at the same speed. The cylinders will contain residual solvent from the earlier brushing-out operation and this must first be removed. Accordingly, the timer next switches on the air heater and fans to supply hot air to the duct 55 which will be directed on to the surfaces of the cylinders and extracted through the duct 57, a certain amount of the exhaust air being extracted to remove solvent fumes. At the end of the period set for the drying operation the control system stops the hot air supply and air extraction and causes the ultra-violet tubes in compartments 51 to be switched on. These cause the whole of the surface of the cylinder to be irradiated as the cylinders rotate, so curing all the exposed photopolymeric material. At the end of the required exposure period the control system switches off the ultra-violet tubes and causes the spray system to operate to spray the surface of the cylinders with a detackifying solution. Suitable solutions are known in the art and form no part of this invention. After the whole of the surface has been sprayed as required the control system switches off the spray supply and again switches on the air heater and fans to cause a further supply of hot air to effect a final drying of the cylinder surfaces. After a suitable period the hot air supply is switched off and the motor stopped. After a delay during which the cylinders cool the interlock releases allowing the doors 61 to be opened, the upper mounting plates 16 are raised using the foot pedal and the finished cylinders are removed from the enclosure.

Although the invention has been described in the particular context of processing photopolymer printing cylinders it will be apparent that it is not so limited and that the surfaces of any cylindrical objects may be treated. Thus, the compartments between the rear wall 4 and the intermediate wall 5 may be arranged to suit the particular desired process and the treatment means associated with each of those compartments may be varied. More than one set of spray equipment may be incorporated for association with each cylinder so that more than one type of liquid may be sprayed on to the cylinder surface.

The apparatus may be designed to accommodate any required number of cylinders for simultaneous processing. The particular drive arrangement and mounting arrangement may also be varied from those shown.

CLAIMS:

1. Apparatus for processing the surface of a cylindrical object in a number of sequential steps, the apparatus comprising an enclosure, mounting means in the enclosure for releasably engaging opposite ends of a cylindrical object to support said object within the enclosure, drive means for rotating said mounting means to rotate said object about its axis, a plurality of treatment means directed towards the location of said object when mounted, and means controlling operation of the treatment means in a desired sequence as said object is rotated.

2. Apparatus according to claim 1 in which the apparatus is designed to be used with the object mounted so that its axis is vertical.

3. Apparatus according to claim 1 or claim 2 in which each treatment means is designed to treat simultaneously the full axial length of the object.

4. Apparatus according to any one of the preceding claims in which the treatment means includes means for directing radiation on to the surface of the object.

5. Apparatus according to any one of the preceding claims in which the treatment means includes means for directing liquid on to the surface of the object.

6. Apparatus according to any one of the preceding claims in which the treatment means includes means for directing a drying flow of hot air on to the surface of the object.

7. Apparatus for processing the surface of an exposed photopolymer printing sleeve of cylindrical form, the apparatus comprising an enclosure, mounting means within the enclosure for releasably engaging opposite ends of the sleeve to support the sleeve within the enclosure, drive means for rotating said mounting means to rotate said object about its axis, first treatment means for directing ultra-violet light on to a surface band extending the full axial length of the object, second treatment means for spraying a detackifying solution on to a surface band extending the full axial length of the object, third treatment means for drying the full axial length of the surface of the object, the three treatment means being angularly spaced around the location of the object and means controlling operation of the treatment means in a desired sequence as said object is rotated.

8. Apparatus according to any one of the preceding claims, for simultaneously treating a plurality of objects, in which a plurality of mounting means are provided in a common enclosure and the treatment means are so arranged that the surface of all objects on the mounting means are treated equally and simultaneously.

9. Apparatus according to claim 8 in which the plurality of mounting means are driven from a common drive means.

10. Apparatus according to any one of the preceding claims in which the or each mounting means comprises upper and lower conical elements for engaging respectively the upper and lower ends of a hollow cylindrical object, the lower element being connected to the drive means, and the upper element being axially movable towards and away from the lower element releasably to engage the cylindrical object.

FIG.1

# FIG.2

0017316

FIG.3

FIG.4

## FIG.5

| | | | | | | | | |
|---|---|---|---|---|---|---|---|---|
| SPRAY | OFF | | | | ON | OFF | | |
| U/V TUBES | OFF | | | ON | OFF | | | |
| HOT AIR FLOW | ON | | | OFF | ON | | OFF | |
| DRIVE MOTOR | ON | | | | | | OFF | |
| DOOR LOCK | ON | | | | | | | OFF |

START                                                  FINISH

## FIG.6